# EUROPEAN PATENT APPLICATION

(11) **EP 2 184 774 A1**
(43) Date of publication of application: **12.05.2010**
(21) Application number: 08168413.6
(22) Date of filing: 05.11.2008
(51) Int. Cl.: H01L 21/58, H01L 21/60

(54) **Low-temperature recoverable electronic component**

(71) Applicant: General Electric Company, Schenectady, NY 12345 (US)
(72) Inventor: Fillion, Raymond Albert, Niskayuna, NY 12309 (US); Mills, Ryan Christopher, Rexford, NY 12148 (US)
(74) Representative: Bedford, Grant Richard

(57) **Abstract**

An electronic component includes a base insulative layer 10 having a first surface 12 and a second surface 14; an electronic device 18 having a first surface 22 and a second surface 24, and the electronic device being secured to the base insulative layer; an adhesive layer 16 disposed between the first surface of the electronic device and the second surface of the base insulative layer; and a removable layer 26 disposed between the first surface of the electronic device and the second surface of the base insulative layer. The base insulative layer secures to the electronic device through the removable layer. The removable layer releases the base insulative layer from the electronic device at a sufficiently low temperature.

## Description

The invention includes embodiments that relate to the fabrication of an interconnect structure. The invention embodiments that relate to a method of recovering a chip or other electrical component from an interconnect structure.

Bonding of electronic devices such as semiconductor chips, discrete passives, BGA carriers or other electrical elements onto printed circuit boards, substrates, interconnect structures or flex circuits is generally done with solders or adhesives. In an area array solder attach assembly, the electrical connections are made by raising the temperature to reflow the solder, which solidifies upon cooling. In applications where the coefficient of thermal expansion (CTE) of the electronic device is not a close match for the CTE of the substrate upon which it is attached, thermal cycling will stress the solder joints and may cause solder fatigue failure. One method to overcome this issue is to encase the solder joints with a polymer resin underfill such as a filled epoxy to stress relieve the solder joints. These underfills can be applied by dispensing liquid resin on one or more sides of a component and allowing the resin to flow under the component by capillary action.

Electronic devices that are sensitive to exposure to high temperature, such as 200 degrees Celsius, should not use a high temperature thermoplastic bonding material. Furthermore, low temperature thermoplastics cannot be exposed to later processing steps such as curing, or to certain assembly steps that exceed their melt or softening temperature. As a result, thermoset adhesives are used in the processing of such electronic devices, because thermoset adhesives can be cured at relatively low temperatures (<200 degrees Celsius), yet are stable at higher temperatures during subsequent processing steps or in use environments. In addition, lower temperature adhesion and bonding is preferred because the zero stress point is established at the bonding temperature, and a lower bonding temperature lowers the stresses in an interconnect assembly at normal operating temperatures.

If a number of electronic devices are attached to a common substrate and one of the devices is found to be defective after solder attach and underfill curing, it is generally desirable to remove the defective device and to replace it with a new part, thus salvaging the substrate and the other electronic devices located on the substrate. A thermoset underfill resin cannot re-melt at a normal processing temperature; thus, the defective electronic device is not removable and the entire circuit must be discarded. Accordingly, the use of low processing temperature, low stress thermoset adhesives results in a non-repairable processing step. Furthermore, the remeltable, reworkable thermoplastic resins require high temperature processing, and result in high stress structures that are not compatible with many planned applications.

Additionally, in embedded chip applications in which an interconnect structure is directly attached to the surface of electronic components a similar issue arises. In these applications, the use of a thermoplastic adhesive to bond the electronic component to the interconnect structure either stresses the structure excessively because of the high thermoplastic melt temperature or severely limits the components operating and/or assembly temperature because of a low thermoplastic melt temperature. In addition, the thermoplastic adhesive may turn liquid during chip to film bonding, permitting the chip to move during processing. Use of a thermoset adhesive in these applications reduces the stress and increases the operating and assembly temperature range, but makes recovery of the electronic component extremely difficult if not impossible.

In a current embedded chip process, referred to as Embedded Chip Build-Up (ECBU) or Chips First Build-Up (CFBU) technology, bare chips are packaged with perimeter or peripheral I/O pads or with an array of I/O pads distributed over the top surface into a high density interconnect structure without the need for either solder joints or wirebonds. The ECBU or CFBU process can be used to form a chip carrier that interconnects a complex semiconductor chip to larger contact pads that are compatible with board level assemblies such as printed circuit boards. These high-end chips may have a value of hundreds of dollars while the carrier formed to interface the chip to the circuit board could have a value an order of magnitude lower. Since all complex interconnect structures have processing defects such as electrical shorts and/or opens, they also have inherent yield losses. In conventional flip chip or wire bonded chip carrier assemblies, the interconnect structure is fully fabricated and electrically tested prior to assembling a costly chip. Thus, a defective interconnect structure does not cause the loss of a costly chip. In the ECBU process, the chip is bonded to the interconnect structure prior to the fabrication of the interconnect structure, potentially causing a good chip to be scrapped with a bad package.

In one embodiment, the invention provides an electronic component. The electronic component includes a base insulative layer having a first surface and a second surface; an electronic device having a first surface and a second surface, and the electronic device being secured to the base insulative layer; an adhesive layer disposed between the first surface of the electronic device and the second surface of the base insulative layer; and a removable layer disposed between the first surface of the electronic device and the second surface of the base insulative layer. The base insulative layer secures to the electronic device through the removable layer. The removable layer releases the base insulative layer from the electronic device at a sufficiently low temperature.

Various aspects and embodiments of the present invention will now be described in connection with the accompanying drawings, in which:
FIGS. 1(a)-1(d) are cross-sectional side views of an electronic device being bonded to a base insulative layer according to an embodiment of the invention.
FIGS. 2(a)-2(c) are cross-sectional side views of an electronic device being bonded to a base insulative layer according to an alternative embodiment of the invention.
FIGS. 3(a)-3(d) are cross-sectional side views of an electronic device being bonded to a base insulative layer according to an alternative embodiment of the invention.
FIGS. 4(a)-4(d) are cross-sectional side views of an electronic device being bonded to a base insulative layer according to an alternative embodiment of the invention.
FIGS. 5(a)-5(b) are cross-sectional side views of an electronic device being bonded to a base insulative layer according to an alternative embodiment of the invention.
FIGS. 6(a)-6(b) are cross-sectional side views of an electronic device being bonded to a base insulative layer according to an alternative embodiment of the invention.
FIG. 7(a) is a top view of a frame panel.
FIG. 7(b) is a cross-sectional side view of a frame panel.
FIGS. 8(a)-8(b) are cross-sectional side views of a frame panel being bonded to a base insulative layer according to an alternative embodiment of the invention.
FIG. 8(c) is a cross-sectional side view of an electronic device being placed within a frame panel on a base insulative layer according to an alternative embodiment of the invention.
FIGS. 9(a)-9(d) are cross-sectional side views of an electronic device being bonded to a base insulative layer and within a frame panel in accordance with an alternative embodiment of the invention.
FIGS. 10(a)-10(d) are cross-sectional side views of an electronic device and a frame panel being bonded to a base insulative layer according to an alternative embodiment of the invention.
FIGS. 11(a)-11(d) are cross-sectional side views of via formation and metallization of the base insulative layer in accordance with an embodiment of the invention.
FIGS. 12(a)-12(b) are cross-sectional side views of an additional base insulative layer being bonded to an interconnect layer according to an alternative embodiment of the invention.
FIGS. 12(c)-12(d) are cross-sectional side views of via formation and metallization of an additional base insulative in accordance with an alternative embodiment of the invention.
FIG. 13 is a cross-sectional side view of an interconnect assembly made in accordance with an alternative embodiment of the present invention.

The invention includes embodiments that relate to the fabrication of an electronic device or interconnect structure. The invention embodiments that relate to a method of recovering a chip or other electrical component from the device. A method may provide for the recovery of an undamaged electronic device, such as a chip, from a defective interconnect structure or package. The methods may be useful in processes involving resin underfills and other embedded chip technology. However, the methods may be used in applications in which the recovery of an electronic device from an interconnect structure or package is desired.

In one embodiment, a method may provide an interconnect structure or an electronic component. The method may include applying a removable layer to an electronic device or to a base insulative layer; applying an adhesive layer to the electronic device or to the base insulative layer; and securing the electronic device to the base insulative layer using the adhesive layer.

The electronic component can include the base insulative layer having a first surface and a second surface; an electronic device having a first surface and a second surface, where the electronic device is secured to the base insulative layer. In the volume defined between opposing surfaces of the electronic device and the base insulative layer, there is an adhesive layer and a removable layer. Particularly, the adhesive layer may be disposed between the first surface of the electronic device and the second surface of the base insulative layer; and the removable layer disposed between the first surface of the electronic device and the second surface of the base insulative layer.

Suitable material for use as the base insulative layer may include one or more of polyimide, polyetherimide, benzocyclobutene (BCB), liquid crystal polymer, bismaleimide-triazine resin (BT resin), epoxy, or silicone. Suitable commercially available materials for use as the base insulative layer may include KAPTON H polyimide or KAPTON E polyimide (manufactured by E. I. du Pont de Nemours & Co.), APICAL AV polyimide (manufactured by Kanegafugi Chemical Industry Company), UPILEX polyimide (manufactured by UBE Industries, Ltd.), and ULTEM polyetherimide (manufactured by General Electric Co.). In the illustrated embodiment, the base insulative layer is fully cured as KAPTON H polyimide.

The base insulative layer may form an interconnect structure, flex circuit, circuit board, or other structure. The interconnect structure can mount and interconnect with one or more electronic devices. With regard to one embodiment, selection properties for the base insulative layer include an elastic modulus and coefficients of thermal and humidity expansion that provide minimal dimensional change during processing. To maintain flexibility, the thickness of the base insulative layer may be minimized. The base insulative layer must have enough rigidity (due to either thickness, a support structure, or material characteristic) to support layers of metallization optionally on both the first and second surfaces, and to maintain dimensional stability through subsequent processing steps.

With regard to the thickness of the base insulative layer, suitable thickness may be selected with reference to the end-use application, the number and type of electronic devices, and the like. The thickness may be greater than about 10 micrometers. The thickness may be less than about 50 micrometers. In one embodiment, the base insulative layer has a thickness in a range of from about 10 micrometers to about 20 micrometers, from about 20 micrometers to about 30 micrometers, from about 30 micrometers to about 40 micrometers, from about 40 micrometers to about 50 micrometers, or greater than about 50 micrometers. With regard to one embodiment where the base insulative layer is a circuit board, its suitable thickness may be based on the number on layers within the circuit board. The number of circuit board layer generally ranges from about 2 to about 50 or more with each layer having a thickness of about 100 micrometers.

The adhesive layer is a thermoset adhesive. Examples of suitable adhesives may include a thermoset polymer. Suitable thermoset polymers may include an epoxy, silicone, acrylate, urethane, polyetherimide, or polyimide. Suitable commercially available thermoset adhesives may include a polyimide such as CIBA GEIGY 412 (manufactutured by Ciba Geigy), AMOCO AI-10 (manufactured by Amoco Chemicals Corporation) and PYRE-MI^{®} (manufactured by E. I. du Pont de Nemours & Co.). CIBA GEIGY 412 has a glass transition temperature of about 360 degrees Celsius. Other suitable adhesives may include thermoplastic adhesive, water cure adhesive, air cure adhesives, and radiation cure adhesives.

In one embodiment, a low-temperature sensitive adhesive layer secures or bonds the electronic device to the base insulative layer - and in this capacity the low-temperature sensitive adhesive layer may function as both an adhesive layer and as a removable layer. The adhesive releases or loses adhesion at a defined low-release temperature.

A suitable low-temperature sensitive adhesive may be a thermoset adhesive. Examples of suitable low-temperature sensitive adhesives include an epoxy or a polyimide. The properties of most commercial adhesives are available, and selection of an adhesive material may be based on such factors as cure temperature, cryo-fracture temperature (if applicable), out-gassing, thermal and oxidative stability, and bond strength at the temperature ranges of interest. Selection of the low-temperature sensitive adhesive may include matching the coefficient of thermal expansion of the low-temperature sensitive adhesive to one or more component of the interconnect device. In one embodiment, the low-temperature sensitive adhesive may have a coefficient of thermal expansion (CTE) in a range of from about 15 ppm/°C to about 20 ppm/°C. The low-temperature sensitive adhesive should lose adhesion at a temperature that is less than the operating temperature of the interconnect device. In addition, a low-temperature sensitive adhesive should be selected that will not chemically interact with the electronic device.

The adhesive layer may be applied to form a layer having a thickness greater than about 5 micrometers on the base insulative layer surface. In one embodiment, the adhesive layer has a thickness in a range of from about 5 micrometers to about 10 micrometers, from about 10 micrometers to about 20 micrometers, from about 20 micrometers to about 30 micrometers, from about 30 micrometers to about 40 micrometers, from about 40 micrometers to about 50 micrometers, or greater than about 50 micrometers.

The adhesive layer may be applied to the base insulative layer by spin coating, spray coating, roller coating, meniscus coating, screen printing, stenciling, pattern print depositing, jetting, or by other dispensing method. In one embodiment, the adhesive is applied by dry film lamination. The adhesive layer may be applied to partially or fully cover the second surface of the base insulative layer. For example, the adhesive layer may be applied to selective areas on the base insulative surface, such as to electronic device mounting sites, while leaving uncoated another area on the base insulative layer surface, such as an electrical contact pad or an electrical test pads. This may be accomplished by direct dispense systems such as jetting, or by stencil or screen printing standard assembly processing steps used to selectively apply solder mask resins onto boards, substrates or components. The direct dispense process may deposit layers with a thickness that is less than about 50 micrometers, and the screen-printing technique may form deposited layers with a thickness that is greater than about 50 micrometers.

In one embodiment, the adhesive layer is deposited onto the electronic device in liquid form and may be dried. The adhesive layer may be applied by itself in liquid form, or may be deposited as part of a liquid solution, e.g. mixed with a solvent. In one example, a suitable liquid thermoset polymer may include 24.8% by weight CIBA GEIGY 412 in a liquid solution comprising 66.4% by weight N-mp, 0.59% by weight of a 0.1% solution of FC 430^{®} (a surfactant commercially available from by 3M Corporation) and 8.3% by weight DMAC. A droplet of this material may be dispensed onto the electronic device in sufficient volume to produce a coating of about 200 micrometers to about 1000 micrometers. After the adhesive layer solution is deposited, the material may be dried in a sequential series of thermal steps, such as 10 to 20 minutes at about 150 degrees Celsius, 10 to 20 minutes at about 220 degrees Celsius and 10 to 20 minutes at about 300 degrees Celsius. The number and duration of the thermal steps, as well as the temperatures used will depend on the particular thermoset polymer or other material that is utilized. This drying sequence removes the solvent from the thermoset adhesive solution, and leaves a fully dried layer of the adhesive layer on the electronic device. The thermoset polymer is fully cross-linked, no longer soluble in the solvent solution, and will not soften unless exposed to extremely high temperatures.

The adhesive layer may be fully cured, if necessary, to bond or secure the electronic device to the base insulative layer. A curing temperature below the melt temperature of the removable layer should be used.

In one embodiment, the removable layer includes a thermoplastic polymer. Suitable thermoplastic polymers for use in forming the removable layer include, but are not limited to, a thermoplastic resin that include a polyolefin, polyimide, polyetherimide, polyether ether ketone, polyether sulfone, silicone, siloxane, or epoxy. Examples of suitable thermoplastic polymers include XU 412 (commercially available from by Ciba Geigy); ULTEM 1000 and ULTEM 6000, which are polyetherimide resins manufactured by GE Plastics; VITREX a polyether ether ketone commercially available from Victrex; XU 218, a polyether sulfone commercially available from by Ciba Geigy; and UDEL 1700®, a polyether sulfone that is commercially available from by Union Carbide.

Suitable methods to apply the removable layer to the electronic device include spray coating, spin coating, roll coating, meniscus coating, dip coating, transfer coating, jetting, drop dispensing, pattern print depositing, or dry film laminating. The removable layer may have a thickness of greater than about 5 micrometers. In one embodiment, the removable layer has a thickness in a range of from about 5 micrometers to about 10 micrometers, from about 10 micrometers to about 20 micrometers, from about 20 micrometers to about 30 micrometers, from about 30 micrometers to about 40 micrometers, from about 40 micrometers to about 50 micrometers, or greater than about 50 micrometers.

The removable layer may be applied to the electronic device while the electronic device is in a single component form, or when the electronic device is in a panel or wafer format. For example, if the electronic device is a semiconductor chip, the removable layer may be applied either at the wafer level, or after the wafer processing is complete and after wafer sawing. The wafer may be sawed into two or more individual chips using semiconductor wafer dicing equipment. The chips may be rinsed to remove sawing debris. Alternatively, the removable layer may be applied directly onto singulated chips after wafer sawing. If the removable layer is applied at wafer level, it may be deposited onto one chip by spin coating or spray coating. If the removable layer is applied to singulated chips, spray coating or drop dispensing may apply the removable layer. In a small packaged electronic device, such as an area array chip scale component, where the electronic device may be fabricated in a panel with multiple devices handled together, the removable layer may be applied by roll coating, meniscus coating or by another batch application method.

The removable layer may be applied to partially or fully cover the first surface of the electronic device. For example, the removable layer material may be applied to selective areas of the electronic device, such as to the device mounting sites, while leaving I/O contacts, or other desired areas on the electronic device uncoated. This may be accomplished by direct dispense systems such as jetting, or by stencil or screen printing standard assembly processing steps used to selectively apply solder mask resins onto boards, substrates or components.

If the removable layer partially covers the first surface of the electronic device, the adhesive layer should correspondingly partially cover the second surface of the base insulative layer. Specifically, the adhesive layer should be applied to selective areas of the electronic device mounting site on the base insulative layer, so that areas on the first surface of the electronic device that are not coated with the removable layer, and do not come in contact with the adhesive when the electronic device is placed against and bonded to the base insulative layer.

The removable layer may be comprised of a soluble or solvent-swellable polymer. Accordingly, a solvent or solvent mixture may be applied to the interconnect structure to dissolve, soften or swell the removable layer. This would release the electronic device from the base insulative layer and interconnect structure. In this method of electronic device recovery, the interconnect structure and attached device may be immersed in a solvent bath. The solvent in the bath contacts and dissolves, softens, or swells at least a portion of the removable layer. This solvation allows the interconnect structure to be removed from the first surface of the electronic device. A low-temperature sensitive electronic device, or other component, is not subject to undesirably high temperatures as used in a heat recovery process. The soluble or solvent-swellable polymer may be a thermoplastic polymer.

Suitable solvents include those that are capable of dissolving, softening or swelling the removable layer. Particular solvents may be selected with reference to the material composition of the removable layer. Depending on the material of the removable layer, suitable solvents may include one or more of acetone, anisole, acetophenone, benzene, toluene, alcohol, g-butylactone, N-methyl pyrrolidone, methylene chloride, and dimethyl sulfoxide (DMSO), and the like. Other suitable solvents include acids and bases for pH sensitive removable layer material, such as sulfuric acid.

In one example, a first solvent mixture of 4 parts meta-cresol and 16 parts orthodichlorobenzene (ODCB) by weight percent and a second solvent mixture of 4 parts meta-cresol and 16 parts acetophenone by weight percent dissolve a solventable removable layer comprised of ULTEM 6000. These ratios of materials may be varied as required. In addition, a solventable polymer comprising PEEK® may be dissolved in concentrated sulfuric acid, and a solventable polymer comprising XU 218 thermoplastic may be dissolved in solvents such as g-butylactone, N-methyl pyrrolidone, methylene chloride, acetone, and acetophenone.

If a functional electronic device is to be recovered from a bad interconnect structure, a solvent should be used that does not chemically react with or harm the electronic device. Alternatively, if it is desired to remove a bad electronic device from a functional interconnect structure, a solvent should be used that does not chemically react with or harm the interconnect structure components (excluding the electronic device and removable layer). Furthermore, a wet etchant may be used in combination with heat to dissolve the removable layer, and to retrieve the electronic device.

The low-temperature sensitive adhesive may be susceptible to loss of adhesion or loss of mechanical strength at a sufficiently low threshold temperature. In one embodiment, the removable layer may be exposed to a low temperature that causes the adhesive material to lose adhesion, thereby releasing the electronic device. In another embodiment, the removable layer may be exposed to a low temperature that causes the adhesive material to become brittle and fracture, thereby releasing the electronic device. A holding device may secure the electronic device and hold onto the interconnect structure. The interconnect structure, including the low-temperature sensitive adhesive may be cooled to a temperature below about -75 degrees Celsius or lower. The temperature is selected based on the properties of the removable layer.

If a functional electronic device is to be separated from a bad base insulative layer and be recovered from the interconnect structure, the interconnect structure should be cooled to a temperature that is higher than the minimum damage threshold temperature of the electronic device. The minimum damage threshold temperature of the electronic device is the minimum temperature the electronic device can be exposed to without damaging the active components of the device. Alternatively, if it is desired to remove a bad electronic device from a functional base insulative layer and be recovered from the interconnect structure, the interconnect structure should be cooled to a temperature that is higher than the minimum damage threshold temperature of the functional base insulative layer. The minimum damage threshold temperature of the functional base insulative layer is the minimum temperature the functional base insulative layer can be exposed to without damaging the components.

After the electronic device is removed from the interconnect structure, residual adhesive layer and electrically conductive material located within the vias may remain on the electronic device. Remaining electrically conducting material or excessive residue adhesive layer on the electronic device surface, and in the vias, may be removed by wet etching, plasma etch, chemical etch or reactive ion etch, and remaining adhesive material may be removed by plasma etch, chemical etch, or reactive ion etch. In addition, if the electrically conductive material is made of metal, the portion of the conductive material remaining on the electronic device may be removed by metal etch. If the electrically conductive material includes Cu or a Ti:Cu bimetal structure, the Cu may be etched with nitric acid to leave the thin Ti metallization in place.

After removing any remaining residual adhesive layer and electrically conductive material from the electronic device the device is in an almost original condition and is ready to be assembled into another interconnect structure.

In one embodiment of forming the removable layer, a thermoplastic polymer is deposited onto the electronic device in liquid form and then dried. The thermoplastic polymer may be applied in liquid form, or may be deposited as part of a liquid solution, e.g. mixed with a solvent. In one example, a suitable solution is formed by adding together CIBY GEIGI XU 412 as a 4.1% by weight solution of 2.5% by weight DMAC (dimethyl acetamide), 27.3% by weight anisole, and 66.1% by weight γ-butyrolactone (GBL). A droplet of this material may be dispensed onto the electronic device in sufficient volume to produce a coating having a thickness in a range of from about 100 micrometers to about 1000 micrometers. After the liquid thermoplastic polymer is deposited, the material may be dried in a sequential series of thermal steps. An example of suitable thermal steps may be 10 to 20 minutes at about 150 degrees Celsius, 10 to 20 minutes at about 220 degrees Celsius, and 10 to 20 minutes at about 300 degrees Celsius. The number and duration of the thermal steps, as well as the temperatures used will depend on the particular thermoplastic polymer that is utilized. This drying sequence removes the solvent from the thermoplastic polymer solution, and leaves a fully dried layer of the thermoplastic polymer on the electronic device, thereby forming the removable layer.

Another factor to consider is the pressure that is applied to the parts during cure. Naturally, more pressure will produce a thinner bond line. If more pressure is needed than a sufficiently thick bondline will allow, spacer material may be added to the adhesive to control the bondline thickness. The spacer material may be selected to be further functional insofar as it may have, as an inherent property, desirable thermal conductivity and electrical resistivity.

If the removable layer is a curable material, after the removable layer is formed it may be cured. The removable layer may be cured thermally, by radiation, or by a combination of heat and radiation. Suitable radiation may include ultraviolet (UV) light, electron beam, and/or microwaves. The cured removable layer should be sufficiently transparent in the visible wavelengths so that automated vision systems at wafer sawing and at chip pick and place can distinguish wafer saw lanes and I/O contact features. This transparency enables alignment of the saw during wafer sawing and alignment of the chip or other electronic device during placement. In addition, the cured removable layer should be laser drillable at the wavelength used to ablate vias through the base insulative layer. For example, the cured removable layer is desirably laser drillable.

Following application of the adhesive layer, the adhesive layer may be cured. The adhesive layer is partially cured until the adhesive is at a B-stage point, where it is not fully cured but stable enough for further handling. The adhesive layer may be cured thermally or by a combination of heat or radiation. Suitable radiation may include UV light and/or microwaves. A partial vacuum may be used to promote the removal of volatiles from the adhesive during cure if any are present.

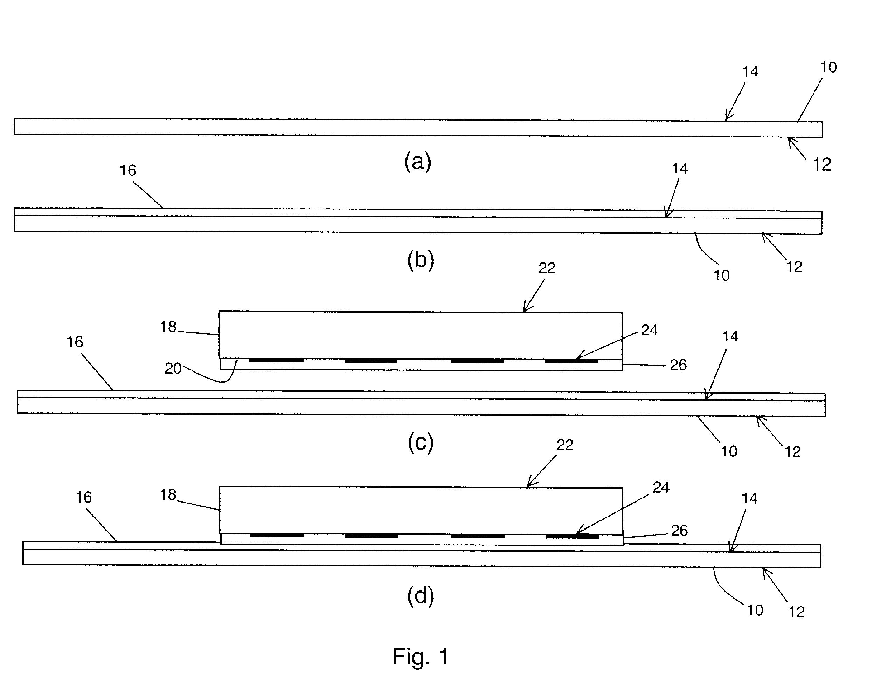

Referring to Fig. 1(a), in one embodiment of the invention a base insulative layer 10 has a first surface 12 and a second surface 14. The base insulative layer is secured to a frame structure (not shown in this Fig.) to provide dimensional stability to the insulative layer during processing. The base insulative layer is formed from an electrically insulating material. Further, the base insulative layer may be a polymer film to which an electrically conductive material can be secured.

As shown in Fig. 1(b), an adhesive layer 16 may be applied to the second surface of the base insulative layer. The adhesive layer can bond to an electronic device 18 (see Fig. 1(c)). The adhesive layer can thus secure or bond the electronic device to the base insulative layer.

As shown in Fig. 1(c), the electronic device has a first surface 20 and a second surface 22. The first surface of the electronic device may be the active surface of the device upon which one or more I/O contacts 24 are located. Examples of I/O contacts, which may be located on the electronic device, include pads, pins, bumps, and solder balls. In the illustrated embodiment, the I/O contacts are I/O pads. Other suitable electronic device may be a packaged or unpackaged semiconductor chip such as a microprocessor, a microcontroller, a video processor, or an ASIC (Application Specific Integrated Circuit); a discrete passive; or a ball grid array (BGA) carrier. In one embodiment, the electronic device is a semiconductor silicon chip with an array of I/O contact pads disposed on its first surface.

Referring further to Fig. 1(c), a removable layer 26 is applied to the first surface of the electronic device. Subsequently, the electronic device and removable layer subassembly may be assembled onto the base insulative layer.

In one embodiment, the active or first surface of the electronic device may be placed in contact with the second surface of the base insulative layer, whereby the active surface of the electronic device having the removable layer thereon, is placed in contact with the adhesive layer (see Fig. 1(d)). For example, the base insulative layer may be placed on a heated stage of an automated Pick and Place system that picks each electronic device, in this case a chip, off of a diced wafer or off of a tray of singulated chips such as a waffle pack. The partially cured adhesive layer is heated whereby the adhesive is softened and made tacky, but is not cured. The chips are then placed with their first surface down, so that the active surface of the chip is placed against the second surface of the base insulative layer, and whereby the I/O contacts of each chip are aligned to fiducials on the base insulative layer (see Fig. 1(d).

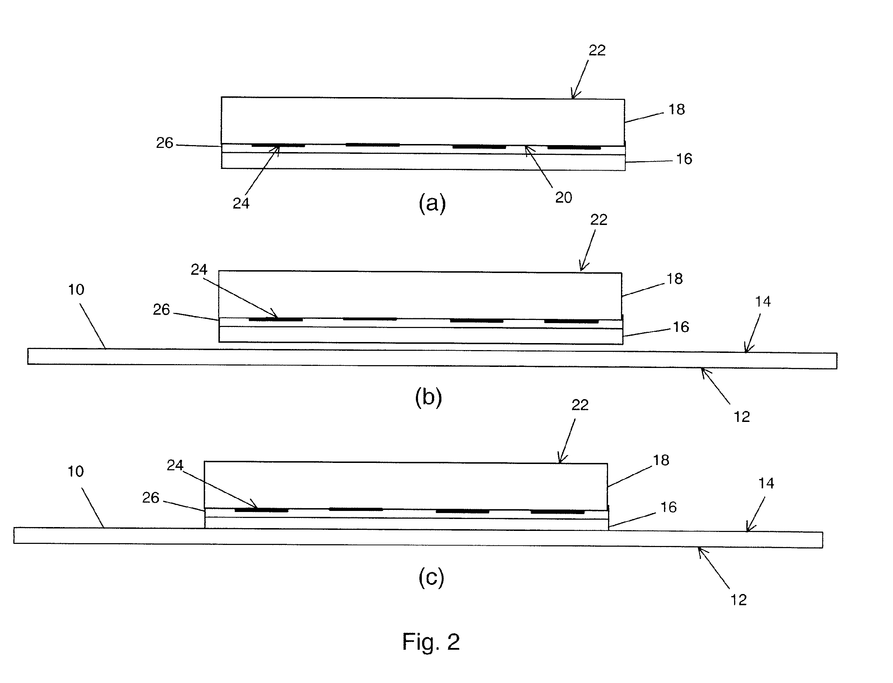

In one embodiment, illustrated in Fig. 2(a), a removable layer is applied to the first surface of an electronic device. The removable layer may be applied to the electronic device and is cured as described above in the first embodiment. An adhesive layer may be applied to the first surface of the electronic device on top of the removable layer, and is used to bond the electronic device to the base insulative layer as shown in Fig. 2(a). Suitable application methods are the same as described hereinabove.

Referring to Fig. 2(c), the active or first surface of the electronic device, having the removable layer and adhesive layer thereon, may be placed in contact with the second surface of the base insulative layer. The base insulative layer has been secured to a frame structure to provide dimensional stability to the insulative layer during processing. In an automated system, the base insulative layer may be placed on a heated stage of an automated Pick and Place system that picks each electronic device, in this case a chip, off of a diced wafer or off of a tray of singulated chips such as a waffle pack. The chips are heated whereby the partially cured adhesive layer is softened and made tacky, but is not cured. The chips are then placed with the electronic device first surface contacting against the second surface of the base insulative layer, and whereby the I/O contacts of each chip are aligned to fiducials on the base insulative layer. The adhesive layer may be fully cured as described hereinabove.

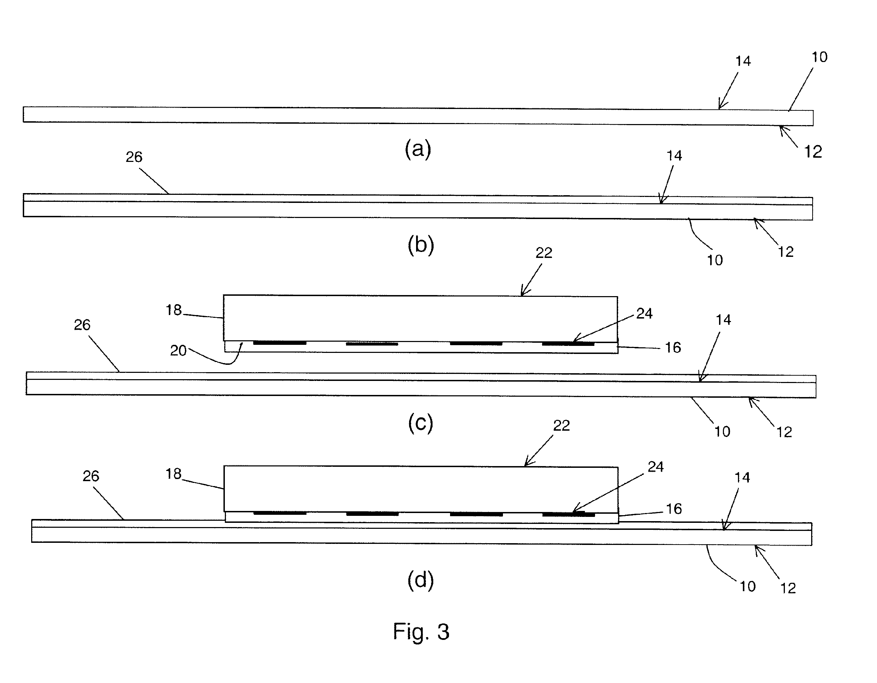

Referring to Fig. 3(a), in one embodiment, a base insulative layer is secured to a frame structure (not shown) to provide dimensional stability to the insulative layer during processing. In this embodiment, as shown in Fig. 3(b), the removable layer is applied to the second surface of the base insulative layer instead of being applied to the electronic device. The removable layer may be applied by a manner as described above.

If the removable layer is removed from selected areas of the base insulative layer, the patterned removable layer may be used as a solder mask material, such that the removable layer is used to define the metal areas to be protected from solder during solder attach reflow. The patterned removable layer, when used as a solder mask, is used in a solder mask defined approach where the solder mask material covers the edges of the solder contact pads and defines the region where the solder will make a bond. Alternatively, the patterned removable layer may be used in a non-solder mask defined approach where the solder mask generally does not overlap the edges of the solder contact pads, but instead the metal pad defines the solder area. The non-solder mask defined approach is less preferred because it may leave small areas around each solder pad where an underfill adhesive can create permanent bonds that may interfere with subsequent electronic device removal. The solder mask is used to cover the traces leading from a solder pad and other adjacent metal features.

Solder attachment for eutectic tin:lead solder undergoes a heating exposure of about 220 degrees Celsius, high lead tin:lead solder undergoes a heating exposure about 300 degrees Celsius, and lead free solders are exposed to temperature of about 240 degrees Celsius to about 260 degrees Celsius. The removable layer material in this embodiment should be selected so that its melt point is above the solder reflow temperature of the selected solder system. The removable layer is the same as described hereinabove.

An adhesive layer is applied to the first surface of the electronic device, and is used to bond the electronic device to the base insulative layer (see Fig. 3(c)). The adhesive layer is applied to the electronic device as described above. However, in this embodiment, the adhesive layer is applied directly onto the first surface of the electronic device, instead of being applied onto the outward facing surface the removable layer pre-assembled with the electronic device.

If the removable layer is applied to partially cover areas of the electronic device-mounting site on the base insulative layer, the adhesive layer should be applied to partially cover the first surface of the electronic device. Specifically, the adhesive layer should be applied to selective areas on the electronic device, so that areas on the second surface of the base insulative layer that are not coated with the removable layer, do not come in contact with the adhesive when the electronic device is placed against and bonded to the base insulative layer. The adhesive layer may be partially cured until the adhesive is in the B-stage.

The active or first surface of the electronic device may be placed in contact with the second surface of the base insulative layer. The active surface of the electronic device has the adhesive layer disposed thereon and contacts the removable layer (see Fig. 3(d)). An automated Pick and Place system may be used to place the electronic device onto the base insulative layer. The adhesive layer may be cured to bond the electronic device to the base insulative layer. A curing temperature below the melt temperature of the removable layer should be used.

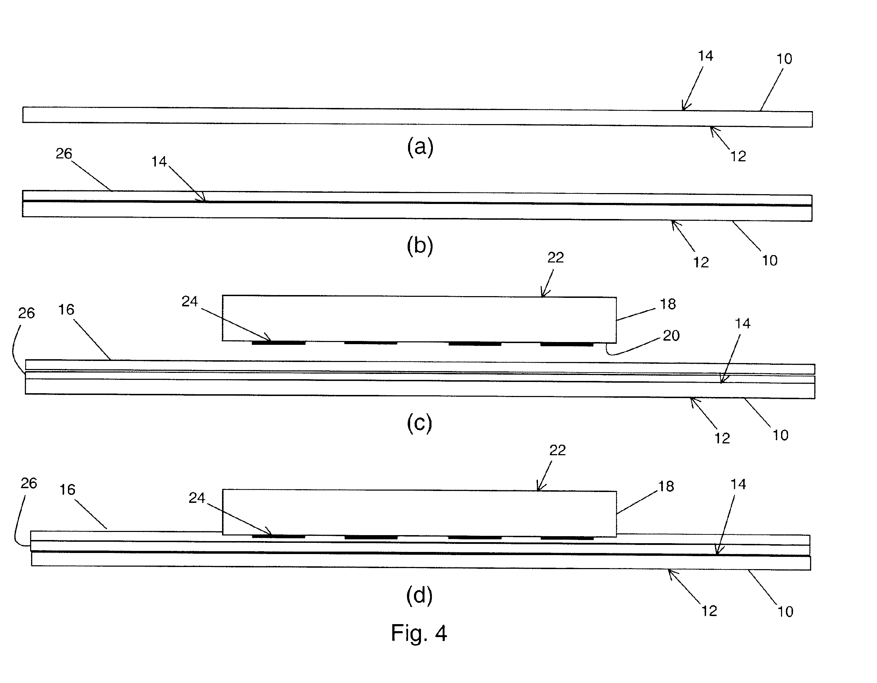

In one embodiment, a base insulative layer has a first surface and a second surface (see Fig. 4(a)). The base insulative layer secures to a frame structure (not shown) to provide dimensional stability to the insulative layer during processing. In this embodiment, the removable layer is applied to the base insulative layer, and is cured as described above (see Fig. 4(b)).

As shown in Fig. 4(c), an adhesive layer is applied to the second surface of the base insulative layer onto an outward facing surface of the removable layer. The adhesive layer may be applied as indicated above.

The active or first surface of the electronic device may be placed in contact with the second surface of the base insulative layer, whereby the active surface of the electronic device is placed in contact with the adhesive layer (see Fig. 4(d)) on the base insulative layer. An automated Pick and Place system may be used to place the electronic device onto the base insulative layer.

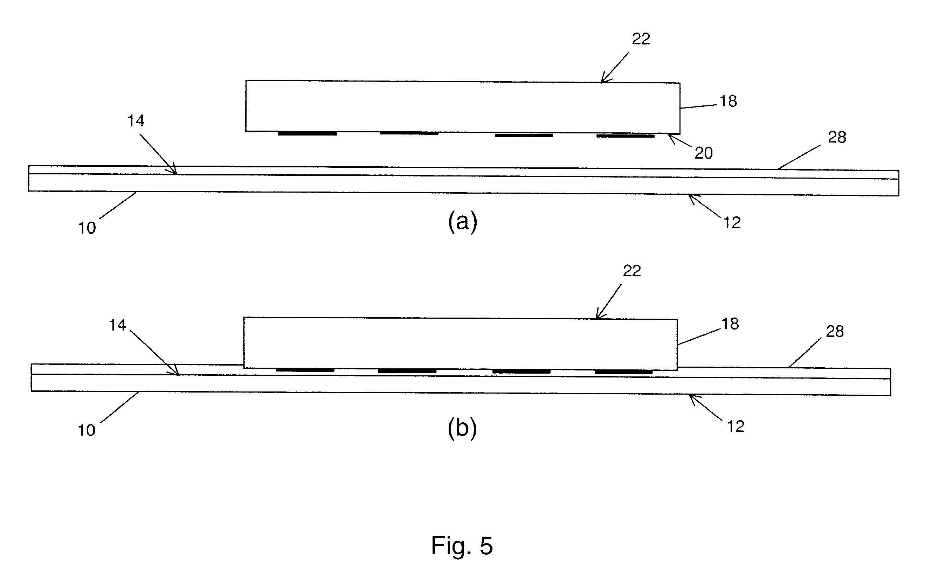

Referring to Figs. 5(a) and 5(b), the low-temperature sensitive adhesive layer 28 is applied to the second surface of the base insulative layer and bonds at least one electronic device to the base insulative layer. The low-temperature sensitive adhesive may be useful where the adhesive effectively bonds the electronic device to the base insulative layer during processing and use.

The active or first surface of the electronic device may be placed in contact with the second surface of the base insulative layer, whereby the active surface of the electronic device, is placed in contact with the low-temperature sensitive adhesive (see Fig. 5(b)). For example, the base insulative layer may be placed on a heated stage of an automated Pick and Place system that picks each electronic device, in this case a chip, off of a diced wafer or off of a tray of singulated chips such as a waffle pack. If only partially cured, the low-temperature sensitive adhesive may be heated, whereby the adhesive is softened and made tacky. The chips are then placed with their first surface down, so that the active surface of the chip is placed against the second surface of the base insulative layer, and whereby the I/O contacts of each chip are aligned to fiducials on the base insulative layer. The low-temperature sensitive adhesive may be fully cured to bond the electronic device to the base insulative layer.

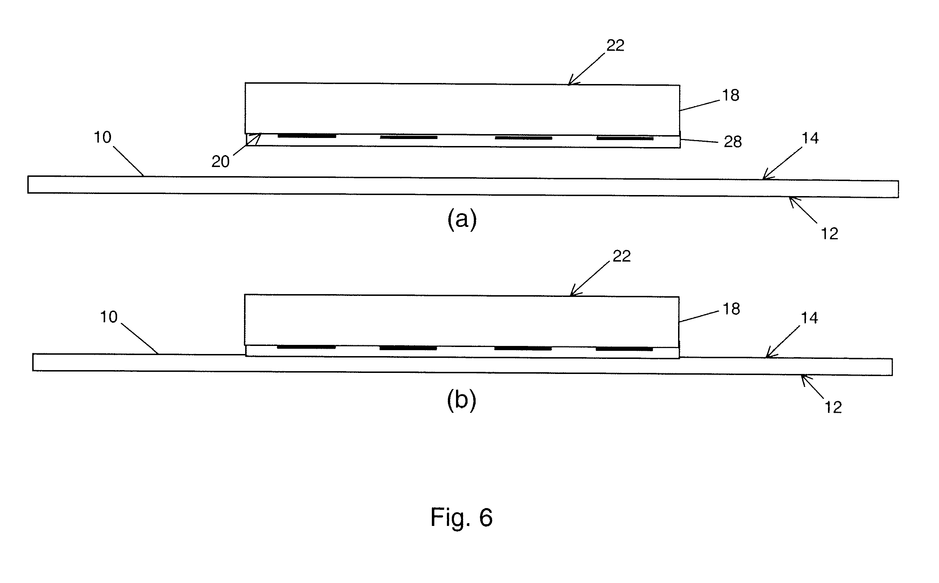

In one embodiment, the low-temperature sensitive adhesive is applied to first surface of the electronic device instead of the base insulative layer, as shown in Fig. 6(a). The low-temperature sensitive adhesive may be partially cured until the adhesive is in the B-stage. The low-temperature sensitive adhesive can be handled, processed and assembled as described above. Subsequently, the low-temperature sensitive adhesive is fully cured.

The active or first surface of the electronic device, having the low-temperature sensitive adhesive thereon, may contact the second surface of the base insulative layer (see Fig. 6(b)). The base insulative layer may be secured to a frame structure to provide dimensional stability to the insulative layer during processing.

To recover the electronic device from the interconnect structure and base insulative layer, an encapsulation step may be delayed until a final processing step. However, if the electronic device is left unencapsulated on the base insulative layer during processing, the base insulative layer may be subject to patterning issues due to the non-planarity of the unencapsulated surface.

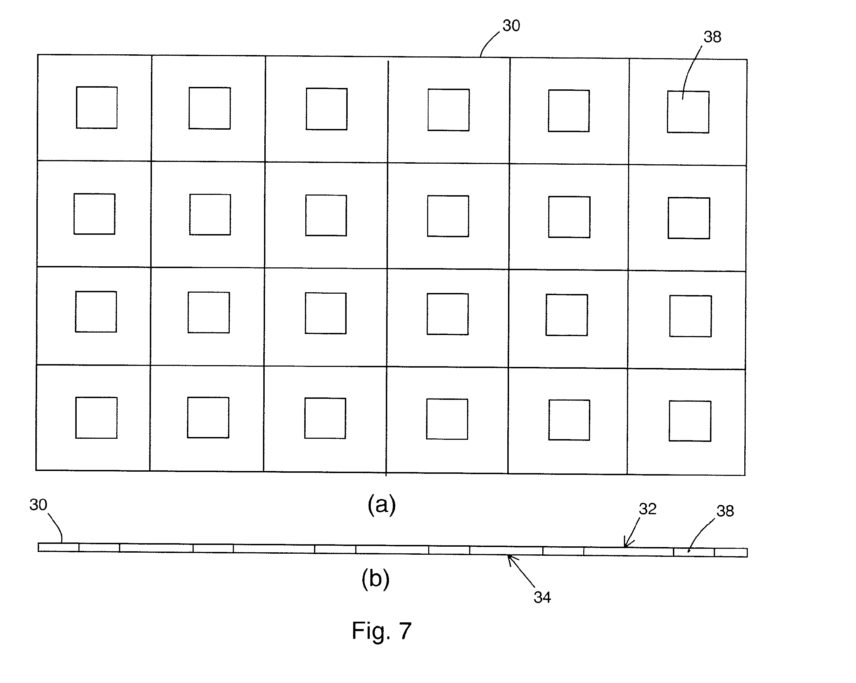

The base insulative layer secures to a frame structure to provide dimensional stability to the base insulative layer during processing. In one embodiment, a frame panel 30 has a first surface 32 and a second surface 34. The frame has a surface that defines an aperture or an opening 38 for each electronic device site on the base insulative layer (see Figs. 7(a) and 7(b)).

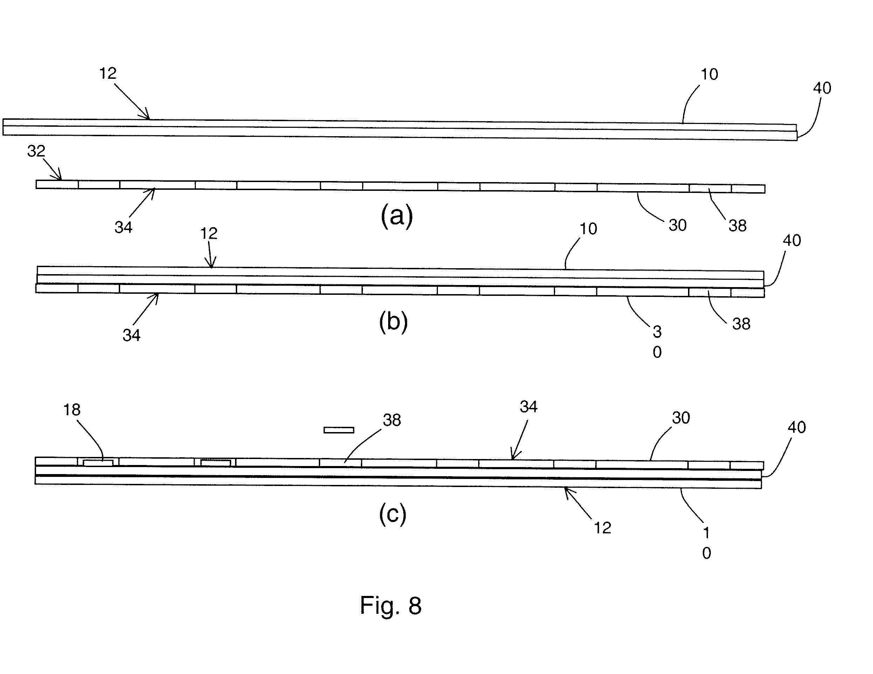

The base insulative layer may secure to the frame panel as shown in Fig. 8. The frame panel stabilizes the base insulative layer instead of, or in addition to, the frame structure (shown hereinabove) during fabrication of the interconnect structure. Furthermore, the frame panel may increase the planarity of the unencapsulated surface of the base insulative layer during processing. The frame panel may be a relatively permanent component of the interconnect structure. As shown in Fig. 7(a), the frame panel may be large enough to comprise a plurality of openings 38, wherein each opening is for a different electronic device site on the base insulative layer, and whereby the frame panel provides stability and increased planarity to a plurality of electronic device sites. Alternatively, the frame panel may comprise a single opening and be sized to provide stability and increased planarity to one electronic device site on the base insulative layer.

A suitable frame panel may be formed from a metal, ceramic, or a polymeric material. Suitable polymeric materials may include a polyimide, or an epoxy or epoxy blend. The polymeric material may include one or more reinforcing fillers. Such filler may include fibers or small inorganic particles. Suitable fibers may be glass fibers or carbon fibers. Suitable particles may include silicon carbide, boron nitride, or aluminum nitride. The frame panel may be a molded polymer structure. In one embodiment, the frame panel is a metal selected from titanium, iron, copper or tin. Or, the metal may be an alloy or metal composite, such as stainless steel or Cu:Invar:Cu. The specific materials from the frame panel is formed may be selected for a particular design based on the desired coefficient of thermal expansion, rigidity, or other desired mechanical properties. The frame panel may have a metal coating. Suitable metal for coating may include nickel. The frame panel may have a polymer coating. Suitable polymer coating materials may include polyimide, which may improve adhesion.

The frame structure and/or frame panel may stabilize the base insulative layer during processing. However, the use of a frame structure or frame panel may not be required. For example, roll-to-roll processing may not require the use of a frame structure or frame panel.

The frame panel may have a coefficient of thermal expansion (CTE) that is greater than about 10 ppm/°C. The frame panel may have a coefficient of thermal expansion (CTE) that is less than about 20 ppm/°C. In one embodiment, the frame panel may have a thickness equal or close to the thickness of the electronic device.

In one embodiment, the first surface of the frame panel secures to the second surface of the base insulative layer (see Figs. 8(a) and 8(b)). The base insulative layer may bond to the frame panel using an adhesive layer 40. Suitable adhesives for bonding the frame panel to the base insulative layer include at least those materials listed hereinabove as suitable adhesive materials. Suitable application methods include those listed hereinabove.

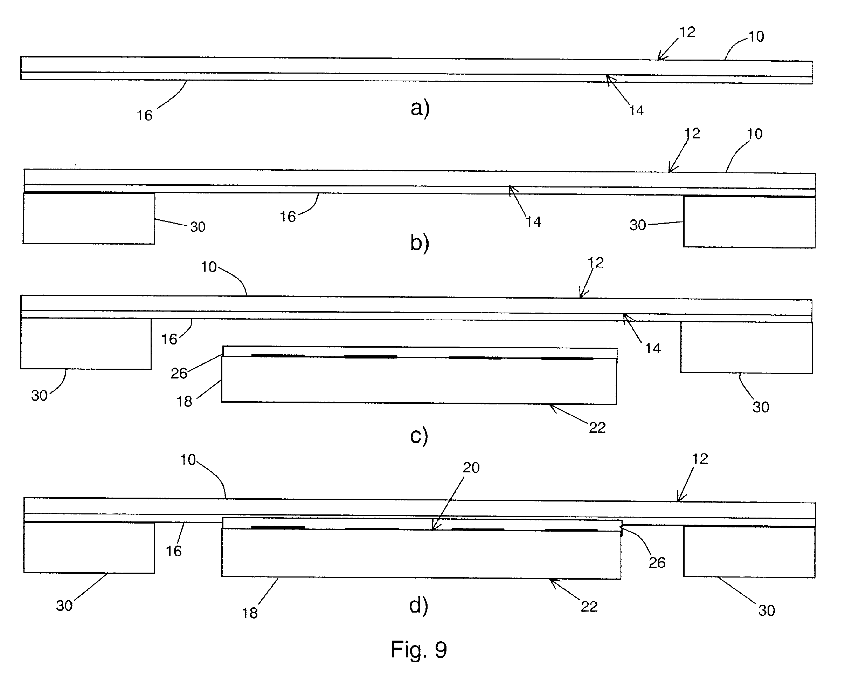

In addition, if the adhesive layer used to bond the frame panel to the base insulative layer is the same as the adhesive layer used to bond the electronic device to the base insulative layer, the electronic device and frame panel may be placed onto the base insulative layer and cured at the same time. This may simplify or reduce the number of the processing steps. For example, as illustrated in Fig. 9, the second surface of the base insulative layer 14 is coated with a thermoset adhesive layer 16, and the adhesive material is cured to a B-stage. The second surface of the base insulative layer is laminated to the first surface of the frame panel 30 as shown in Fig. 9(b). An electronic device 18 having a removable layer already secured thereto, is placed on the second surface of the base insulative layer within an opening in the frame panel 30 (see Figs. 9(c) and 9(d)). The adhesive layer is fully cured to bond both the frame panel and the electronic device to the base insulative layer.

Each opening in the frame panel may be in a range of from about 0.2 millimeters (mm) to about 5 mm larger in the x and y dimensions than the electronic device. This size multiplier may facilitate a subsequent placement of the electronic device onto the base insulative layer. Alternatively, the frame panel may be placed onto the base insulative layer after the electronic device is placed and/or bonded onto the base insulative layer.

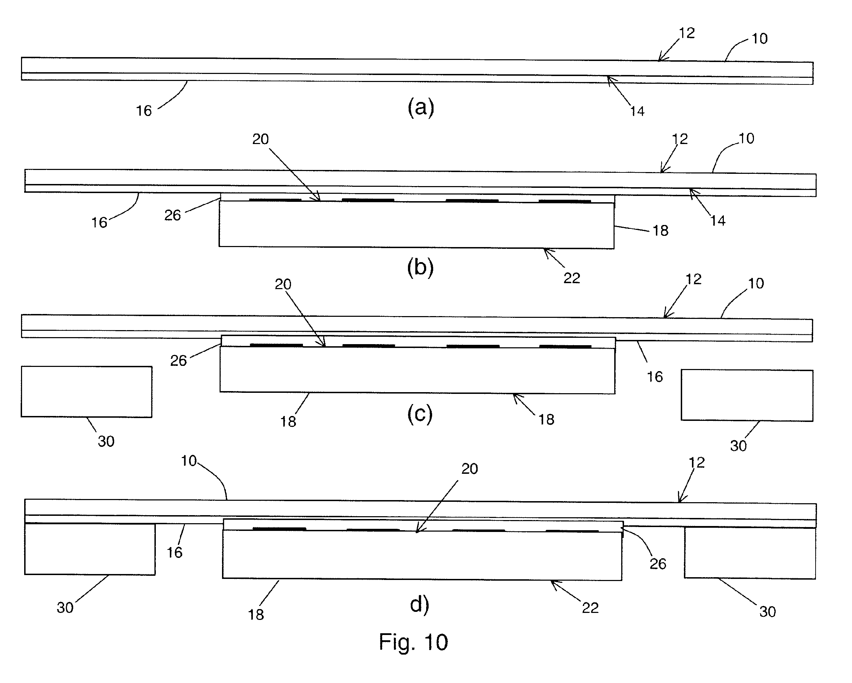

Referring to Fig. 10(a), for example, the second surface of a base insulative layer is coated with an adhesive layer and the adhesive is cured to a B-stage. An electronic device with a removable layer thereon is placed onto the second surface of the base insulative layer as shown in Fig. 10(b). The second surface of the base insulative layer is laminated to the first surface of the frame panel as displayed in Figs. 10(c) and 10(d). The electronic device is disposed within an opening in the frame panel. Lastly, the adhesive layer is fully cured to bond the frame panel and the electronic device to the base insulative layer.

In one embodiment, a sub-assembly includes a removable layer and an adhesive layer with a barrier coating disposed therebetween to form a sandwich. The barrier coating may block migration of reactive species from the adhesive layer, and may prevent the adhesive layer from reacting with the removable layer during processing. Such a reaction, were it to occur, may cause a weak interface or defect point between the removable layer and the adhesive layer. For example, a thermoset adhesive layer may react with the thermoplastic material of a removable layer during high temperature processes, such as curing.

The barrier coating may be applied to an outward facing surface ("on top of") the removable layer after the removable layer has been applied to the electronic device, or after the base insulative layer and the removable layer are cured. The barrier coating may be either an organic or an inorganic layer. In the embodiment where an organic barrier coating is used, it may be applied to the base insulative layer or electronic device by a method indicated herein as suitable for the application of either of the adhesive layer or the removable layer, including, but not limited to chemical vapor deposition, plasma deposition, or reactive sputtering. In the embodiment where an inorganic barrier coating is used, it may be deposited by CVD, evaporation or sputtering for example. If the barrier coating is applied to a surface of the electronic device, the barrier coating may be applied at the wafer level, after the wafer processing is complete and prior to wafer sawing. Alternatively, the barrier coating may be applied onto singulated chips after wafer sawing.

The barrier coating may include one or more organic materials selected from polyolefins, polyesters, or amorphous hydrogenated carbon. Other suitable barrier coatings may be formed from inorganic materials, such as Ta₂O₅ Al₂O₃, Sb₂O₃, Bi₂O₃, WO₃, or ZrO₂.

In one embodiment, an electrical connection between the electronic device and the base insulative layer is formed after the electronic device bonds to the base insulative layer. Specifically, an electrical connection is made between the I/O contact(s) located on the electronic device and the electrical conductor(s) located on the base insulative layer.

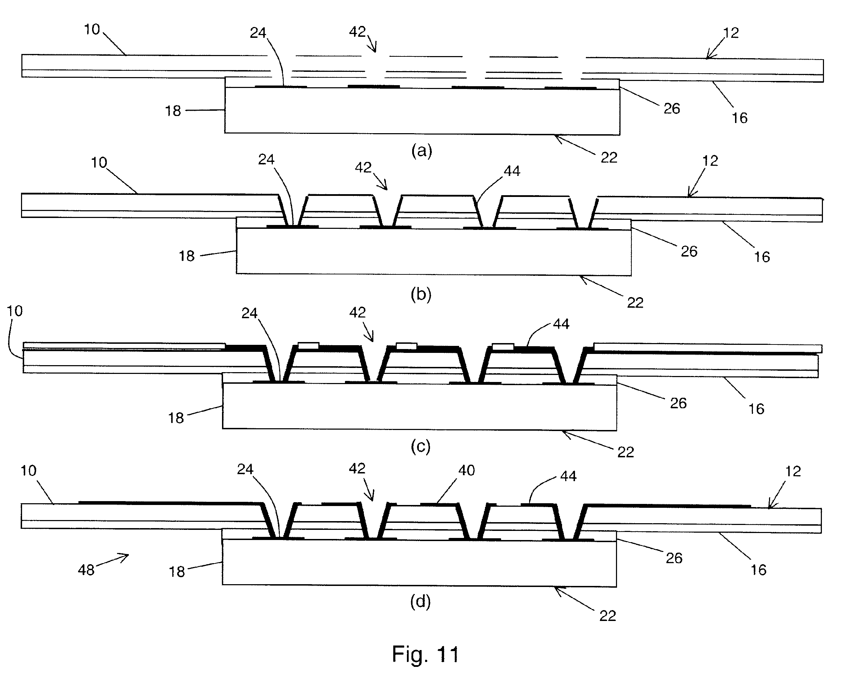

Referring to Fig. 11, suitable electrical conductors 40 that may be located on the base insulative layer include pads, pins, bumps, and solder balls. The electrical connection between the base insulative layer and the electronic device may be a structure selected based on application specific parameters. For example, apertures, holes, or vias 42 may be created through the base insulative layer, the adhesive layer, and the removable layer to one or more I/O contacts on the electronic device (see Fig. 11). In one embodiment, the vias may be sized so that they are micro-vias. Laser ablating, mechanical drilling, punching, wet chemical etching, plasma etching, or reactive ion etching may form the vias.

If laser ablation technique forms the vias, the base insulative layer may be supported by a frame structure, and may be turned over and placed onto an automated laser system. The laser system may be programmed to laser ablate the base insulative layer in selected locations. This process forms blind vias through the base insulative layer, adhesive layer, and removable layer to a plurality of the I/O contacts 24 on the electronic device 18. If desired, the laser ablation may be followed by a de-smear or de-scum process that removes residue ash and residue adhesive layer in the via to expose the I/O contacts on the electronic device. This step may be performed by Reactive Ion Etch (RIE), plasma clean or wet chemical etch. If desired, traces, power planes or ground planes may be formed on the first surface of the base insulative layer.

Referring to Fig. 11(b), electrically conductive material, indicated by reference number 44, may be disposed into the vias extending to the I/O contacts on the electronic device and onto the first surface of the base insulative layer 10. The electrically conductive material may be an electrically conductive polymer, and may be deposited by jetting or by screening. Examples of suitable electrically conductive materials may include an epoxy, polysulfone, or polyurethane that incorporates metal particle fillers. Suitable metal particles include silver and gold. Other suitable metals may include Al, Cu, Ni, Sn, and Ti. Rather than filled polymeric material, inherently conductive polymers may be used. Suitable conductive polymers include polyacetylene, polypyrrole, polythiophene, polyaniline, polyfluorene, Poly-3-hexylthiophene, polynaphthalenes, poly-p-phenylene sulfide, and poly-p-phenylene vinylene. If viscosity and stability issues are addressed, the inherently conductive polymer may be filled with an electrically conductive filler to further enhance the electrical conductivity.

If the conductive material is metal, the conductive material may be deposited by methods including one or more of sputtering, evaporating, electroplating, or electroless plating. In one embodiment, the first surface of the base insulative layer and the exposed surface of the vias extending to the I/O contacts on the electronic device are metallized using a combined sputter plate and electroplate sequence. The base insulative layer is placed in a vacuum sputter system with the first surface of the base insulative layer and the vias exposed to the sputter system. A backsputter step sputter-etches the exposed device I/O contacts to remove residual adhesive material and native metal oxide. Further, backsputter step etches into the base insulative layer surface. The sputter etch of the metal I/O contacts reduces contact resistance of the subsequent metallization steps while the etching of the base insulative layer may increase the metal adhesion to the first surface of the base insulative layer.

As shown in Fig. 11(b), a seed metal layer 44 is sputter deposited onto the first surface of the base insulative layer, onto the sidewalls that define the via, and onto the exposed I/O contacts. A dual-metal system containing a barrier metal such as Ti or Cr, and a non-barrier metal such as Cu or Au may be used. The barrier metal can plate to a thickness in a range of from about 1000 Å to about 3000 Å, and the non-barrier metal can plate to a thickness in a range of from about 0.2 micrometers to about 2.0 micrometers. The metal deposition steps may form metal interconnections on the first surface, or the non-component side, of the base insulative layer.

Following the sputtering steps, a relatively thicker layer of the non-barrier seed metal layer is electroplated onto the base insulative layer first surface, as indicated in Fig. 11(c). A suitable metallization patterning process may include a semi-additive or pattern plate-up process as depicted in Fig. 11. The metallized surfaces of the base insulative layer including the via sidewalls are electroplated with metal to form a layer with a thickness in a range of from about 2 micrometers to about 20 micrometers. Referring to Fig. 11 (c), a photomask material is disposed over the first surface of the base insulative layer and photo-patterned to expose selected regions of the surface. Areas on the first surface of the base insulative layer that are desired to retain metal such as interconnect traces, I/O contacts and vias are left covered with the photoresist; and, areas of the base insulative surface that are intended to have the metal removed are exposed and not covered. Multiple wet metal etch baths remove plated up and sputtered metal in the exposed base insulative layer surface regions, while the remaining areas are protected from the wet etchants by the masking material. Following completion of the etching step, the remaining photoresist material is removed. The photoresist material removal reveals the desired metallization pattern, as shown in Fig. 11(d).

In one sequence, a subtractive metal patterning process is used. In this method, a photomask material is disposed over the first surface of the base insulative layer, and then photo-patterned to expose selected regions of the surface. Areas on the first surface of the base insulative layer that are desired to retain metal such as interconnect traces, I/O contacts, and vias are left covered with the photoresist while areas of the base insulative layer surface that are desired to have the metal removed are left uncovered as indicated in Fig. 11(c). The exposed metallized areas of the first surface of the base insulative layer, including the via sidewalls, are electroplated to a thickness in a range of from about 4 micrometers to about 20 micrometers. Because the plated-up metal will have sidewalls that follow the straight sidewalls of the patterned photoresist, the photoresist thickness should be greater than the thickness of the plated-up metal. Following the completion of the plate-up process step, the remaining photoresist material is removed, revealing the metallized regions on the first surface of the base insulative layer where the seed metal was not plated-up as indicated in Fig. 11(d). Multiple standard wet metal etch baths may remove the exposed seed metal to leave the desired metallization pattern. An electrical connection between the base insulative layer and the electronic device may also be formed using a solder process.

The preceding process steps complete a first interconnect layer 48 and its electrical connections to the I/O contacts of the electronic device. Interconnection to one or more complex electronic devices, including semiconductor chips such as microprocessors, video processors and ASICs (Application Specific Integrated Circuits), may require an additional interconnection layer to fully route out all of the required chip I/O contacts. For these electronic devices, one or more additional interconnect layers may be formed over the first surface of the base insulative layer. For more simple electronic devices with less routing complexity, only one interconnect layer may be required.

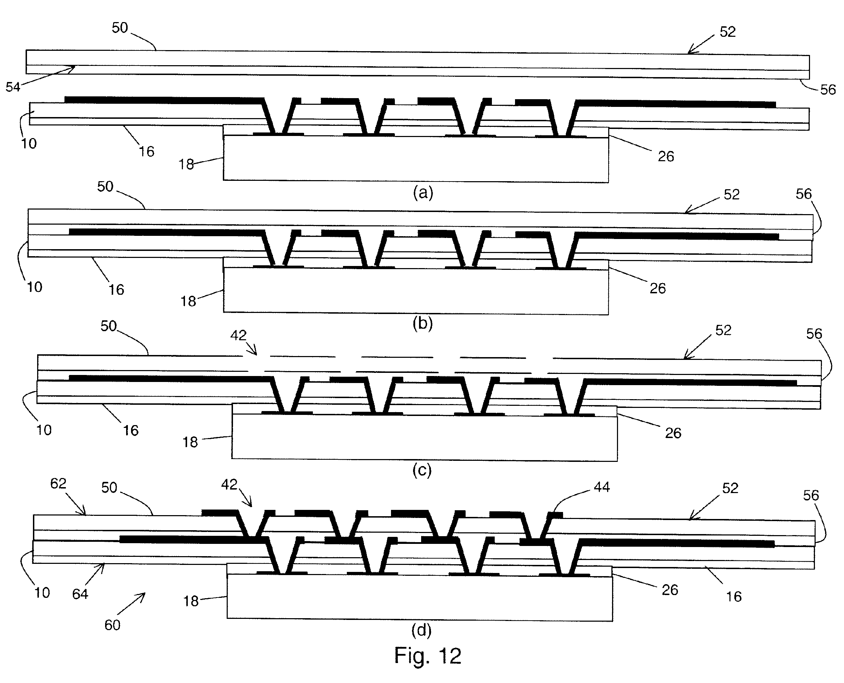

In one embodiment, additional interconnection layers are formed by bonding an additional insulative layer 50 to the first interconnect layer. In one embodiment indicated in Fig. 12(a), the additional insulative layer has a first surface 52 and a second surface 54, and is coated with an adhesive layer 56. Suitable adhesives for use in the invention include those materials indicated as being suitable adhesive materials hereinabove. If the adhesive layer includes a thermoset material, after application of the adhesive layer to the additional insulative layer, the adhesive is cured to a B-stage.

Suitable methods to apply the adhesive layer to the additional interconnection layers include spray coating, spin coating, roll coating, meniscus coating, dip coating, transfer coating, jetting, drop dispensing, pattern print depositing, or dry film laminating. The adhesive layer may have a thickness of greater than about 5 micrometers. In one embodiment, the removable layer has a thickness in a range of from about 5 micrometers to about 10 micrometers, from about 10 micrometers to about 20 micrometers, from about 20 micrometers to about 30 micrometers, from about 30 micrometers to about 40 micrometers, from about 40 micrometers to about 50 micrometers, or greater than about 50 micrometers. In an alternative embodiment, the adhesive layer may be a prefabricated self-adhesive film that is applied to a surface of the additional insulative layer.

Referring to Fig. 12(b), the second surface of the additional insulative layer is placed in contact with the base insulative layer first surface (non-component side). The adhesive layer is fully cured to bond the additional insulative layer to the base insulative layer and to interconnect layer 48. In one embodiment, the additional insulative layer is laminated over the first surface of the base insulative layer using a heated vacuum lamination system.

The electrical conductor(s) 40 on the additional insulative layer is electrically connected to the electrical conductor(s) 40 on the base insulative layer. For example, vias may be formed through the additional insulative layer and through the adhesive layer to selected electrical conductors on the base insulative layer, as shown in Fig. 12(c). The same process steps used to form vias and deposit electrically conducting material in the first interconnect layer, as described above, may be used to form electrically conducting vias in the additional insulative layer and adhesive layer (see Fig. 12(d)).

In one embodiment, the first surface of the additional insulative layer is metallized to complete the second interconnect layer using the metallization and patterning steps described above for the first interconnect layer. A plurality of additional interconnect layers may be formed in a similar manner.

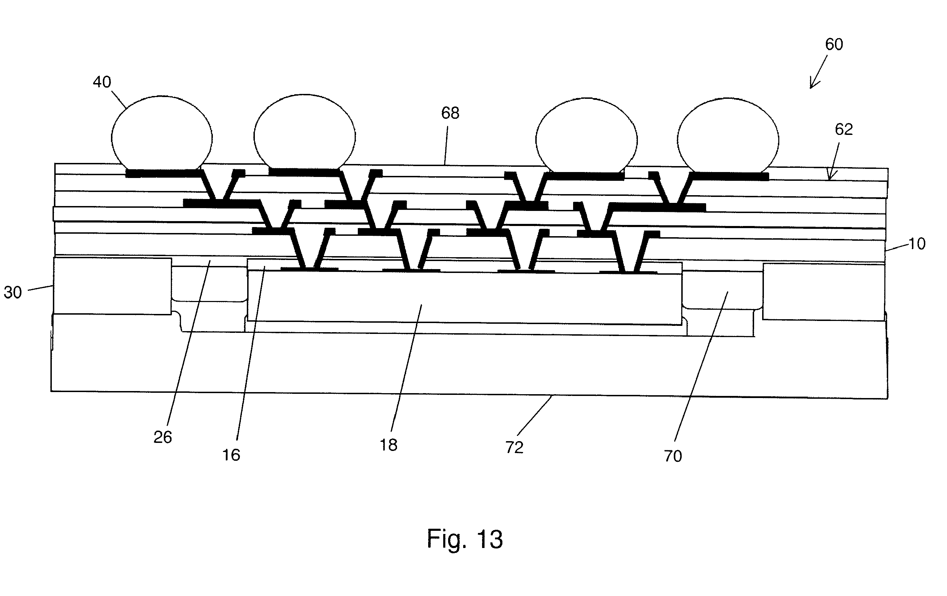

Multiple interconnect layers cooperate to define an interconnect assembly 60 as displayed in Figs. 12(d) and 13. The interconnect assembly has a first surface 62 and a second surface 64. The interconnect assembly may be completed by coating the first surface of the assembly with a dielectric or solder masking material 68 to passivate any metal traces and to define contact pads used for assembly or package I/O contacts. The package I/O contacts may have additional metal depositions such as Ti:Ni:Au applied to the exposed contact pads to provide more robust I/O contacts. The additional metal depositions may be applied by electroless plating. The I/O contact pads can have pins, solder spheres, or leads attached to them or left as is creating a pad array. Fig. 13 depicts an interconnect assembly 60 with an array of solder spheres such as for a ball grid array. Other interconnect structures may also be used. For example, an interconnect assembly may have an array of pins such as for a pin grid array.

At the completion of the interconnect structure, which can be either an interconnect layer or an interconnect assembly that includes multiple interconnect layers, a standard electrical test station determines if all of the interconnects are correct. By correct it means that the circuit is without opens or shorts. If testing indicates that an interconnect structure is defective, or another component on the interconnect structure is defective, a good electronic device may be recovered from the defective package. Alternatively, if the electronic device is found to be defective, the defective device may be removed from the interconnect structure and replaced with a new one.

In one embodiment, the removable layer may have a softening temperature or a melt point. The electronic device may be recovered from the interconnect structure by heating the removable layer to its softening temperature or melt point. At that temperature, the electronic device to be released or removed from the base insulative layer and interconnect structure can be recovered. The removable layer is exposed to a heat source to soften or melt the removable layer. Using this technique, the interconnect structure may be peeled off of the electronic device, as the electronic device is firmly secured by a holding device. A suitable holding device may employ a vacuum or a mechanical clamp. The claim may grasp the edge of the interconnect structure and remove or peel the interconnect structure from the electronic device.

The removable layer permits the electronic device to be retrieved without damage to the electronic device or the elements on its active surface. This is of particular concern with emerging semiconductor devices that use a low K (dielectric constant) interlayer dielectric because they have low mechanical strength and are damaged.

In an alternative method of removal, the interconnect structure may be mounted on a heated stage wherein a secondary heating source provides localized heating to the electronic device and the area surrounding the device. The removable layer is heated to its softening temperature or to its melt point. If the removable layer comprises a thermoplastic or a thermoset polymer, the removable layer may be softened or melted by exposing the removable layer to a temperature that is determined by the material properties of the polymer. Suitable temperature ranges may be in a range of from about 250 degrees Celsius to about 350 degrees Celsius.

If a functional and undamaged electronic device is to be separated from a bad base insulative layer, the melting point temperature of the removable layer should be lower than the maximum damage threshold temperature of the electronic device. The maximum damage threshold temperature of the electronic device is the maximum temperature the electronic device (including any circuitry thereon) can be exposed to without damaging the electronic device. Alternatively, if it is desired to remove a bad electronic device from a functional and undamaged base insulative layer, the melting point temperature of the removable layer should be lower that the maximum damage threshold temperature of the base insulative layer. The maximum damage threshold temperature of the base insulative layer (including any circuitry thereon) is the maximum temperature the base insulative layer can be exposed to without damaging the components. Thus, from the interconnect structure, the defective electronic device or any of the defective remaining components may be removed.

In one embodiment, an interconnect structure includes a flip chip or chip scale electronic device that utilizes a relatively fine pitch (about 50 micrometers to about 1000 micrometers) array of solder spheres to electrically connect the electronic device to the base insulative layer to define and form the interconnect structure. The removable layer should be applied prior to an underfill application, otherwise the solder attached electronic device is removable if it is found to be defective prior to underfill curing, but is not readily removable after underfill curing. The underfill may encapsulate the solder spheres after they reflow, and electrically connect the electronic device to the interconnect structure solder pads. Thus, the underfill bonds to the removable layer rather than to the substrate. Application of the removable layer under the electronic device mounting site permits removal of the electronic device after underfill curing has occurred.

In one embodiment, the interconnect structure may mount on a heated stage. A secondary heating source applies localized heating to the electronic device and to the area surrounding the device. The removable layer and the solder connection attaching the electronic device to the interconnect structure are heated to their softening point or melt point. This releases the removable layer and the electronic device, and permits the electronic device to be removed from the mounting site while the thermoset underfill remains fully intact. The prior mounting site may be cleaned to remove residue or debris. Lastly, a new electronic device with solder spheres may then be mounted on the interconnect structure, solder attached and underfilled to complete the replacement of the defective component.

If the electronic device is electrically attached to the interconnect structure by a solder connection, such as a solder ball or an electrically conductive polymer lead, the electrical connection and the removable layer, should be heated to its melt point or softening point to remove the electronic device from the interconnect structure. Physical connections between the electronic device and interconnect structure formed by electrically conducting polymer materials may be heated to melt or soften the conducting material to release the electronic device. Alternatively, if possible, such electrical connections may be physically broken after the removable layer has been melted or softened.

Chip-on-Flex, Plastic high density interconnects (HDI), high I/O count processor chips may benefit by employing embodiments disclosed herein. In the Chip-on-Flex process, a complex interconnect structure needs to be fabricated after the electronic device is bonded to the base insulative layer. It is complex in the number of layers required to route the high number of chip I/O pads, and in the complexity of each interconnect layer needed. This may have an unfortunate defect rate per interconnect structure, such as about 2% to about 10%. A yield loss of the complex interconnect structure risks scrapping the costly processor chip unless a rework process is available. Recovery by one or more of the disclosed methods may provide a relatively low stress recovery process for a bond that is stable over normal operating temperatures, can withstand high solder reflow temperatures, but is removable if an electronic component needs to be recovered from an interconnect structure.

In one embodiment, encapsulation may be delayed until the final processing step to allow for removal of the electronic device from the interconnect structure. After the interconnect layers are complete and testing of the interconnect structure is performed. If the interconnect structure and electronic device are found to be without defects, the area surrounding the electronic device may be encapsulated to further protect the electronic device and the interconnect structure from moisture and thermo-mechanical stresses. The base insulative layer and exposed electronic device may be encapsulated with encapsulation material 70 to fully embed the base insulative layer and the electronic device (see Fig. 13). In another embodiment, the base insulative layer and exposed electronic device may be partially encapsulated to embed the base insulative layer and the electronic device (see Fig. 13). In one embodiment, a potting or molding process is used to encapsulate. Suitable molding processes may include pour molding, transfer molding, or compression molding. Preferably, a dam and fill encapsulation method is utilized.

Encapsulation materials that may be used include thermoplastic and thermoset polymers. Suitable aliphatic and aromatic polymers may include polyetherimides, acrylates, polyurethanes, polypropylene, polysulfone, polytetrafluoroethylenes, epoxies, benzocyclobutene (BCB), room temperature vulcanizable (RTV) silicones and urethanes, polyimides, polyetherimides, polycarbonates, silicones, and the like. In one embodiment, the encapsulation material is a thermoset polymer due to the relatively low cure temperatures available. The encapsulation material may include a filler material. The type, size and amount of the filler material may be used to tailor various molding material properties, such as thermal conductivity, thermal coefficient-of-expansion, viscosity and moisture uptake. For example, these materials may include particles, fibers, screens, mats, or plates of inorganic particles. Suitable filler materials may include glass, silica, ceramic, silicon carbide, alumina, aluminum nitride, boron nitride, gallium, or other metals, metal oxide, metal carbides, metal nitrides, or metal silicides. Other suitable filler materials may include carbon-based materials.

If a frame panel is used, it can be applied prior to the attachment of the electronic device (see Fig. 9), after the attachment of the electronic device (see Fig. 10), or after completion of the of the interconnect assembly (see Fig. 14). In the latter approach, the adhesive is applied to the major surface of the frame panel and bonded to the second surface of the interconnect assembly. In all of these frame-panel-attach methods, a gap or moat region may exist between the inner edges of each frame panel opening, and the outer edge of the electronic device disposed within the opening. This gap may either be left unfilled or may be fully or partially filled with encapsulation material. The gap between the inner edges of the frame panel opening, and the outer edge of the electronic device may be partially filled so that they are between about 10% full and about 90% full. The encapsulation material may be cured. In certain embodiments, it may be beneficial to simultaneously cure the encapsulation material and the adhesive layer.

After the base insulative layer and exposed electronic device are encapsulated, a lid/thermal spreader 72 may be bonded to the second surface of the electronic device to provide thermal protection to the electronic device. The lid/thermal spreader is bonded with a thermal interface material (TIM) 74. The lid/thermal spreader may also be bonded to the second surface of the frame panel using an adhesive 76. Alternatively, the backside of the electronic device may be left exposed to facilitate heat removal during device operation for higher power devices with about 5 watts to about 100 watts or more dissipation.

The embodiments described herein are examples of compositions, structures, systems and methods having elements corresponding to the elements of the invention recited in the claims. This written description may enable those of ordinary skill in the art to make and use embodiments having alternative elements that likewise correspond to the elements of the invention recited in the claims. The scope of the invention thus includes compositions, structures, systems and methods that do not differ from the literal language of the claims, and further includes other structures, systems and methods with insubstantial differences from the literal language of the claims. While only certain features and embodiments have been illustrated and described herein, many modifications and changes may occur to one of ordinary skill in the relevant art. The appended claims cover all such modifications and changes.

Various aspects and embodiments of the present invention will now be defined in the following numbered clauses:
1. An electronic component, comprising:
   a base insulative layer having a first surface and a second surface;
   an electronic device having a first surface and a second surface, and the electronic device being secured to the base insulative layer;
   an adhesive layer disposed between the first surface of the electronic device and the second surface of the base insulative layer; and
   a removable layer disposed between the first surface of the electronic device and the second surface of the base insulative layer, wherein the base insulative layer secures to the electronic device through the removable layer, which is capable of releasing the base insulative layer from the electronic device at a sufficiently low temperature.
2. The electronic component as defined in clause 1, wherein the adhesive layer is closer to electronic device than the removable layer.
3. The electronic component as defined in any preceding clause, wherein the removable layer is closer to electronic device than the adhesive layer.
4. The electronic component as defined in any preceding clause, wherein the removable layer allows the electronic device to be retrieved from the base insulative layer without damaging the electronic device.
5. The electronic component as defined in any preceding clause, further comprising an I/O contact on the first surface or the second surface of the electronic device, and an electrical conductor located on the first surface or the second surface of the base insulative layer, wherein the I/O contact is in electrical communication with the electrical conductor.
6. The electronic component as defined in any preceding clause, wherein the base insulative layer is a polymer film.
7. The electronic component as defined in any preceding clause, wherein the film has an average thickness in a range of from about 10 micrometers to about 50 micrometers.
8. The electronic component as defined in any preceding clause, wherein the base insulative layer comprises at least one of a polyimide, polyetherimide, benzocyclobutene, liquid crystal polymer, bismaleimide-triazine resin, epoxy, or silicone.
9. The electronic component as defined in any preceding clause, wherein the removable layer comprises a thermoplastic polymer.
10. The electronic component as defined in any preceding clause, wherein the removable layer has a thickness that is less than about 100 micrometers.
11. The electronic component as defined in any preceding clause, wherein the removable layer has a plurality of sub-layers capable of delaminating from each other to aid in removal of the electronic device from the base insulative layer.
12. The electronic component as defined in any preceding clause, wherein the removable layer releases at a temperature that is less than about - 50 degrees Celsius.
13. The electronic component as defined in any preceding clause, wherein the adhesive layer comprises a thermoset polymer.
14. The electronic component as defined in any preceding clause, wherein the adhesive comprises an epoxy, silicone, acrylate, urethane, polyetherimide, or polyimide.
15. The electronic component as defined in any preceding clause, wherein the adhesive layer is b-stageable, and has a cure temperature that is lower than a melt temperature of the removable layer.
16. The electronic component as defined in any preceding clause, further comprising a barrier coating disposed between the removable layer and the adhesive layer.
17. The electronic component as defined in any preceding clause, wherein the barrier coating comprises of a polyolefin, a polyester, or amorphous hydrogenated carbon.
18. The electronic component as defined in any preceding clause, wherein the barrier coating comprises a polysilane-siloxane copolymer or an OSiMeR.
19. The electronic component as defined in any preceding clause, wherein the barrier coating comprises Ta₂O₅, Al₂O₃, Sb₂O₃, Bi₂O₃, WO₃, or ZrO₂.
20. The electronic component as defined in any preceding clause, further comprising an electrical connection structure, which comprises:
   at least one via extending from the first surface of the base insulative layer to an I/O contact on the first surface of the electronic device; and
   electrically conductive material disposed within at least a portion of the via, the electrically conducting material extending through the via to the I/O contact on the electronic device.
22. The electronic component as defined in any preceding clause, wherein the electrically conductive material comprises an electrically conductive polymer or a metal.
23. The electronic component as defined in any preceding clause, further comprising electrically conductive traces, power planes or ground planes on the first surface of the base insulative layer.
24. The electronic component as defined in any preceding clause, further comprising an electrical connection structure, which comprises a solder ball or an electrically connective pathway formed from a solder ball.
25. The electronic component as defined in any preceding clause, further comprising a frame panel having a first surface, a second surface, and at least one aperture for an electronic device site on the base insulative layer, wherein the first surface of the frame panel is secured to the second surface of the base insulative layer.
26. The electronic component as defined in any preceding clause, further comprising encapsulation material that fully embeds the second surface of the base insulative layer and the electronic device.
27. The electronic component as defined in any preceding clause, wherein the encapsulation material comprises a liquid crystal polymer, polyamide, polycarbonate, polyether imide, polypropylene, polysulfone, polyimide, polyurethane, epoxy, or silicone.
28. The electronic component as defined in any preceding clause, further comprising encapsulation material that partially embeds the second surface of the base insulative layer and the electronic device.
29. The electronic component as defined in any preceding clause, further comprising:
   an additional insulative layer having a first surface and a second surface, wherein the second surface of the additional insulative layer is secured to the first surface of the base insulative layer; and
   an electrical connection between an electrical conductor located on the additional insulative layer and an electrical conductor on the base insulative layer.
30. The electronic component as defined in any preceding clause, further comprising a lid/thermal spreader in thermal communication with the electronic device.
31. The electronic component as defined in any preceding clause, wherein the electronic device is a semiconductor chip.

## Claims

1. An electronic component, comprising:
a base insulative layer (10) having a first surface (12) and a second surface (14);
an electronic device (18) having a first surface (20) and a second surface (24), and the electronic device being secured to the base insulative layer;
an adhesive layer (16) disposed between the first surface of the electronic device and the second surface of the base insulative layer; and
a removable layer (26) disposed between the first surface of the electronic device and the second surface of the base insulative layer, wherein the base insulative layer secures to the electronic device through the removable layer, which is capable of releasing the base insulative layer from the electronic device at a sufficiently low threshold temperature.

2. The electronic component as defined in claim 1, wherein the removable layer (26) loses sufficient mechanical strength at the threshold temperature to allow the electronic device to be retrieved from the base insulative layer without damaging the electronic device.

3. The electronic component as defined in any preceding claim, further comprising an I/O contact (24) on the first surface or the second surface of the electronic device, and an electrical conductor located on the first surface or the second surface of the base insulative layer, wherein the I/O contact is in electrical communication with the electrical conductor.

4. The electronic component as defined in any preceding claim, wherein the removable layer (26) has a plurality of sub-layers capable of delaminating from each other to aid in removal of the electronic device from the base insulative layer.

5. The electronic component as defined in any preceding claim, wherein the removable layer (26) releases at a temperature that is less than about - 50 degrees Celsius.

6. The electronic component as defined in any preceding claim, wherein the adhesive layer (16) is b-stageable, and has a cure temperature that is lower than a melt temperature of the removable layer.

7. The electronic component as defined in any preceding claim, further comprising a barrier coating disposed between the removable layer (26) and the adhesive layer (16).

8. The electronic component as defined in any preceding claim, further comprising an electrical connection structure, which comprises:
at least one via extending from the first surface of the base insulative layer to an I/O contact (24) on the first surface of the electronic device; and
electrically conductive material disposed within at least a portion of the via, the electrically conducting material extending through the via to the I/O contact on the electronic device (18).

9. The electronic component as defined in any preceding claim, further comprising a frame panel (30) having a first surface, a second surface, and at least one aperture for an electronic device site on the base insulative layer, wherein the first surface of the frame panel is secured to the second surface of the base insulative layer (10).

10. The electronic component as defined in any preceding claim, wherein the electronic device (18) is a semiconductor chip.
